# EUROPÄISCHE PATENTSCHRIFT

(11) **EP 2 803 939 B1**
(45) Veröffentlichungstag und Bekanntmachung des Hinweises auf die Patenterteilung: **09.03.2016**
(21) Anmeldenummer: 14001619.7
(22) Anmeldetag: 08.05.2014
(51) Int. Cl.: F41H 13/00, H01M 10/052, H01S 3/04

(54) **Vorratsmodul zum Versorgen eines Waffensystems sowie Waffensystem mit Vorratsmodul**
Supply module for supplying a weapons system and weapons system with supply module
Module de réserve destiné à alimenter un système d'armes et système d'armes avec module de réserve

(30) Priorität: 16.05.2013 DE 102013008407
(43) Veröffentlichungstag der Anmeldung: 19.11.2014
(73) Patentinhaber: MBDA Deutschland GmbH, 86529 Schrobenhausen (DE)
(72) Erfinder: Protz, Rudolf, D-85635 Höhenkirchen-Siegertsbrunn (DE)

(56) Entgegenhaltungen:
- DE-B4-102008 054 264
- US-A- 3 392 259
- US-A1- 2011 113 949

## Beschreibung

Die vorliegende Erfindung betrifft ein Vorratsmodul zum Versorgen eines Waffensystems. Weiterhin umfasst die vorliegende Erfindung ein Wirksystem, umfassend ein zu versorgendes Waffensystem und das Vorratsmodul. Besonders bevorzugt ist das zu versorgende Waffensystem ein Laserwaffensystem.
Bei Konzepten für Hochenergielaser-Waffensysteme werden für die Erzeugung der Laserstrahlung oftmals diodengepumpte Festkörperlaser in der Leistungsklasse von etwa 100 kW vorgeschlagen. Die vorgeschlagenen Hochenergielaser-Waffensysteme besitzen Lasergeräte, die üblicherweise einen Wirkungsgrad von etwa 20% aufweisen. Daher ist im Betrieb eine sehr hohe Kühlleistung von 80% der aufgewandten elektrischen Leistung nötig, wobei eine Stabilisierung der Kühlmitteltemperatur auf wenige Grad Celsius genau vonnöten ist. Betrachtet man die zuvor genannte Größenordnung der diodengepumpten Festkörperlaser von einigen hundert Kilowatt, so stellt die Kühlung der Lasergeräte eine sehr große Herausforderung dar.
Aus dem Stand der Technik ist bekannt, dass die elektrische Versorgung und Kühlung von Lasergeräten mit einem entsprechend dimensionierten elektrischen Generator und einem hinreichend großen Kühlaggregat erfolgen kann. Solche Versorgungsgeräte besitzen aber bei den erforderlichen Leistungen eine sehr große Masse und ein sehr großes Volumen. Insbesondere eine Realisierung einer Laserwaffe auf einem mobilen Trägerfahrzeug wird dadurch unmöglich.

Die US2011/113949A1 bildet einen Ausgangspunkt für Anspruch 1 und offenbart ein elektrisches und ein thermisches Vorratsmodul zum Versorgen eines Waffensystems.

Weiterhin ist aus dem Stand der Technik bekannt, dass zur Versorgung der Hochenergielaser-Waffensysteme elektrische Akkumulatoren verwendet werden, die elektrische Energie zum Betreiben des Waffensystems zwischenspeichern. Eine Kühlung kann beispielsweise durch eine hohe Menge an Kühlflüssigkeit erfolgen, wobei sich die Kühlflüssigkeit während des Betriebs des Waffensystems sehr stark erwärmt. Diese Konzepte haben jedoch den großen Nachteil, dass nach einer gewissen Betriebszeit des Waffensystems (typische Dauer etwa eine Minute) ein längerer Zeitraum (typischerweise etwa 15 Minuten) benötigt wird, um die Akkumulatoren erneut aufzuladen und die Kühlflüssigkeit wieder zu entwärmen. Somit ist die Einsatzzeit des Waffensystems sehr stark eingeschränkt.

Aus der DE 10 2011 116 288 A1 ist beispielsweise ein Unterwasserfahrzeug bekannt, dass ein Laser-Wirksystem umfasst. Da Unterwasserfahrzeuge üblicherweise bereits über Energieerzeugungs- und Kühlungssysteme verfügen, greift das Laserwaffensystem auf besagte Systeme des Unterwasserfahrzeugs zurück.

Aus der DE 10 2012 000 672 A1 ist hingegen ein Laser-Waffensystem bekannt, dass stationär betrieben wird. Hier wird durch eine spezielle Anordnung von Energiespeichern versucht, die von einem stationären Generator erzeugte Energie zu speichern, um diese konzentriert an das Laser-Waffensystem abgeben zu können. Durch eine verteilte Anordnung der Energiespeicher soll ein Übertragen eines hohen Stroms vermieden werden.

Aus der DE 60 2004 000 303 T2 wiederum ist ein elektrohydraulisches Aggregat bekannt. Hier treibt ein Elektromotor eine Pumpe an, mittels der ein Fluiddruck im Hydrauliksystem aufgebaut wird. Innerhalb eines Akkumulators wird schließlich der Hydraulikdruck gespeichert, um somit eine hydraulische Leistungsreserve zur Verfügung zu stellen.

Zuletzt ist aus der DE 10 2008 054 264 B4 eine multifunktionale Service- und Testeinrichtung für unbemannte Flugkörper bekannt. Die Service- und Testeinrichtung umfasst dabei unter anderem auch die Möglichkeit, den Flugkörper mit extern zugeführter elektrischer Energie vom Stromnetz des Servicegeräts zu versorgen.

Es ist daher Aufgabe der Erfindung, ein Versorgungsmodul für ein Waffensystem, insbesondere für ein Hochenergielaser-Waffensystem, bereitzustellen, das bei einfacher und kostengünstiger Herstellung und Montage ein geringes Gewicht und ein geringes Volumen aufweist, dabei aber einen langen Einsatzzeitraum des Waffensystems ermöglicht. Es ist weiter Aufgabe der Erfindung, ein Wirksystem bereitzustellen, das ebenfalls die zuvor genannten Eigenschaften erfüllt.

Die Aufgabe wird gelöst durch die Merkmale der unabhängigen Ansprüche.

Somit wird die Aufgabe gelöst durch ein Vorratsmodul, das zur Versorgung eines Waffensystems verwendbar ist. Das erfindungsgemäße Vorratsmodul umfasst eine elektrische Speichervorrichtung sowie eine thermische Speichervorrichtung. Die elektrische Speichervorrichtung ist insbesondere derart ausgelegt, dass diese elektrische Energie über einen langen Zeitraum speichert. Die thermische Speichervorrichtung ist ausgebildet, ein Kühlmittel zu speichern. Erfindungsgemäß ist weiterhin vorgesehen, dass zumindest ein elektrischer Anschluss vorhanden ist, über den elektrische Energie aus der elektrischen Speichervorrichtung an das Wirksystem übertragbar ist. Ein thermischer Anschluss erlaubt hingegen das Übertragen des Kühlmittels aus der thermischen Speichervorrichtung an das Wirksystem. Eine derartige Anordnung ist insbesondere dann vorteilhaft, wenn das Waffensystem mobil versorgt werden soll. Hier werden dann keine leistungsstarken Geräte zur Versorgung benötigt. Vielmehr ist erfindungsgemäß vorgesehen, dass das Vorratsmodul zum Versorgen des Waffensystems austauschbar ist.

Die Erfindung betrifft weiterhin ein Wirksystem, das zumindest ein zu versorgendes Waffensystem und zumindest ein Vorratsmodul, wie zuvor beschrieben oder gemäß einer der nachfolgend ausgeführten Weiterbildungen umfasst. Das zu versorgende Waffensystem ist insbesondere eine Laserwaffe. Weiterhin umfasst das Wirksystem zumindest eine Aufnahmevorrichtung, die fest mit dem Waffensystem verbunden ist. Dabei ist das Vorratsmodul in die Aufnahmevorrichtung einbringbar, so dass eine Versorgung des Waffensystems mit elektrischer Energie und mit dem Kühlmittel aus dem Vorratsmodul erfolgt. Daher ist bevorzugt vorgesehen, dass die Aufnahmevorrichtung über eine Fluidleitung und über eine elektrische Leitung mit dem Waffensystem verbunden ist. Diese Verbindung kann insbesondere fest ausgebildet sein, da das Vorratsmodul bevorzugt über den elektrischen Anschluss und den thermischen Anschluss mit der Aufnahmevorrichtung verbunden werden kann, so dass elektrische Energie und Kühlmittel aus dem Vorratsmodul entnommen werden kann. Somit ist vorteilhafterweise das Vorratsmodul zum Versorgen des Waffensystems austauschbar, so dass das Waffensystem nach einer Betriebszeit, die die Vorräte des Vorratsmoduls aufbraucht, nur für die Zeit des Wechselns des Vorratsmoduls nicht einsatzbereit ist. Das Vorratsmodul wiederum kann insbesondere wiederverwendet werden, indem dessen Vorräte wieder aufgefüllt werden.

Die Unteransprüche haben bevorzugte Weiterbildungen der Erfindung zum Inhalt.

Bevorzugt wird vorgesehen, dass der elektrische Anschluss und/oder der thermische Anschluss des Vorratsmoduls eine schnell lösbare Kupplung umfasst. Daher kann das Vorratsmodul schnell, einfach und zuverlässig mit dem Waffensystem verbunden werden, um das Waffensystem mit Kühlmittel und elektrischer Energie zu versorgen. Dabei können die schnell lösbaren Kupplungen des elektrischen Anschlusses oder des thermischen Anschlusses entweder gemeinsam oder unabhängig voneinander mit dem Waffensystem kontaktiert werden.

Vorteilhafterweise ist die elektrische Speichervorrichtung derart ausgebildet, dass diese eine Leistungsdichte von zumindest 1000 Watt pro Kilogramm (W/kg) aufweist. Insbesondere weist die elektrische Speichervorrichtung eine Leistungsdichte von zumindest 3000 W/kg auf. Alternativ oder zusätzlich ist vorgesehen, dass die Energiedichte der elektrischen Speichervorrichtung zumindest 100 Wattstunden pro Kilogramm (Wh/kg) beträgt. Insbesondere beträgt die Energiedichte zumindest 120 Wh/kg. Mit einer derartigen Energieversorgung ist es insbesondere möglich, bei minimalem Gewicht und minimalem Volumen der elektrischen Speichervorrichtung eine maximale Betriebszeit des Waffensystems zu realisieren.

Vorteilhafterweise kann die elektrische Speichervorrichtung eine Energieversorgung des Waffensystems für eine Betriebszeit von zumindest 100 Sekunden aufrechterhalten. Besonders bevorzugt kann die elektrische Speichervorrichtung die Betriebszeit zumindest 150 Sekunden aufrechterhalten. Somit ist das Waffensystem ausreichend lange verfügbar, um Bedrohungen abzuwehren.

Bevorzugt umfasst die elektrische Speichervorrichtung Lithium-Eisenphosphatakkumulatoren. Derartige Akkumulatoren haben eine hohe Lebensdauer, eine geringe Selbstentladung und können oftmals wieder aufgeladen werden. Daher eignen sich derartige Akkumulatoren sehr gut für den Einsatz in Waffensystemen. Insbesondere ist vorgesehen, dass die Lithium-Eisenphosphatakkumulatoren mindestens 1000 Mal wiederaufladbar sind.

In einer vorteilhaften Ausführungsform umfasst die thermische Speichervorrichtung einen Latentwärmespeicher. Dies ist insbesondere derart realisiert, dass das Kühlfluid ein Material enthält, das bei Aufnahme von Wärme seine Phase ändert, ohne dabei seine Temperatur zu verändern. Besonders bevorzugt kann ein derartiges Material Paraffin enthalten, so dass eine Kühlung des Waffensystems dadurch realisiert wird, dass das Paraffin von einem festen Zustand in einen flüssigen Zustand überführt wird. Besonders bevorzugt kann das Kühlmittel eine wässrige Emulsion umfassen, in der mit Paraffin gefüllte Kunststoffkapseln vorhanden sind. Die Durchmesser der Kunststoffkapseln betragen dabei insbesondere 5 µm. Ein derartiges Kühlfluid ist für die Kühlung von Lasersystemen sehr vorteilhaft, da dieses stets seine Temperatur beibehält, während die Kühlung durch die Phasenumwandlung des Paraffins realisiert wird.

Besonders vorteilhaft weist das Kühlmittel eine Latentwärmekapazität von zumindest 20 Kilojoule pro Kilogramm (kJ/kg) auf. Insbesondere weist das Kühlmittel eine Latentwärmekapazität von zumindest 40 kJ/kg auf. Eine Phasenübergangstemperatur ist insbesondere auf 20°C definiert. Derartige Werte ermöglichen eine vorteilhafte Kühlung von Laserwaffensystemen, so dass die entstehende Wärme effektiv abgeführt wird.

Das erfindungsgemäße Wirksystem ist bevorzugt derart ausgebildet, dass eine Beladungsvorrichtung vorhanden ist. Die Beladungsvorrichtung kann bevorzugt ein Kran sein. Durch die Beladungsvorrichtung ist das Vorratsmodul in die Aufnahmevorrichtung einbringbar und/oder aus der Aufnahmevorrichtung ausbringbar. Durch die vorteilhafte Beladungsvorrichtung ist daher das Vorratsmodul schnell und einfach austauschbar, so dass nur eine kurze Standzeit notwendig ist, während der das zu versorgende Waffensystem nicht einsatzbereit ist.

In einer weiteren bevorzugten Ausführungsform des erfindungsgemäßen Wirksystems sind zumindest zwei Aufnahmevorrichtungen vorhanden, wobei eine Versorgung des Waffensystems zwischen den Aufnahmevorrichtungen umschaltbar ist. Auf diese Weise ist das Waffensystem kontinuierlich betreibbar, da von einem ersten Vorratsmodul auf ein zweites Vorratsmodul umgeschaltet werden kann, wenn das erste Vorratsmodul verbraucht ist. Anschließend kann das erste Vorratsmodul aus der Aufnahmevorrichtung entnommen werden, da die Versorgung des Waffensystems durch das zweite Vorratsmodul sichergestellt ist. Ein drittes Vorratsmodul kann in die Aufnahmevorrichtung des ersten Vorratsmoduls eingebracht werden, so dass nach dem Aufbrauchen des zweiten Vorratsmoduls auf das dritte Vorratsmodul umgeschaltet werden kann. Es ist offensichtlich, dass auf diese Weise ein durchgehender Betrieb des Waffensystems ermöglicht ist.

Schließlich ist bevorzugt vorgesehen, dass das Wirksystem eine Plattform umfasst. Auf der Plattform ist bevorzugt das Waffensystem sowie die zumindest eine Aufnahmevorrichtung montiert. Vorteilhafterweise ist die Plattform als mobile Plattform ausgebildet, insbesondere als Landfahrzeug oder als Wasserfahrzeug. Dies hat den Vorteil, dass das Waffensystem stets an einen Ort gebracht werden kann, an dem dieses gerade benötigt wird.

Die Erfindung wird nun anhand von Ausführungsbeispielen unter Berücksichtigung der beigefügten Zeichnungen detailliert beschrieben. In den Zeichnungen ist:
- Figur 1: eine schematische Ansicht des Vorratsmoduls gemäß einem Ausführungsbeispiel der Erfindung, und
- Figur 2: eine schematische Ansicht des Wirksystems gemäß einem Ausführungsbeispiel der Erfindung.

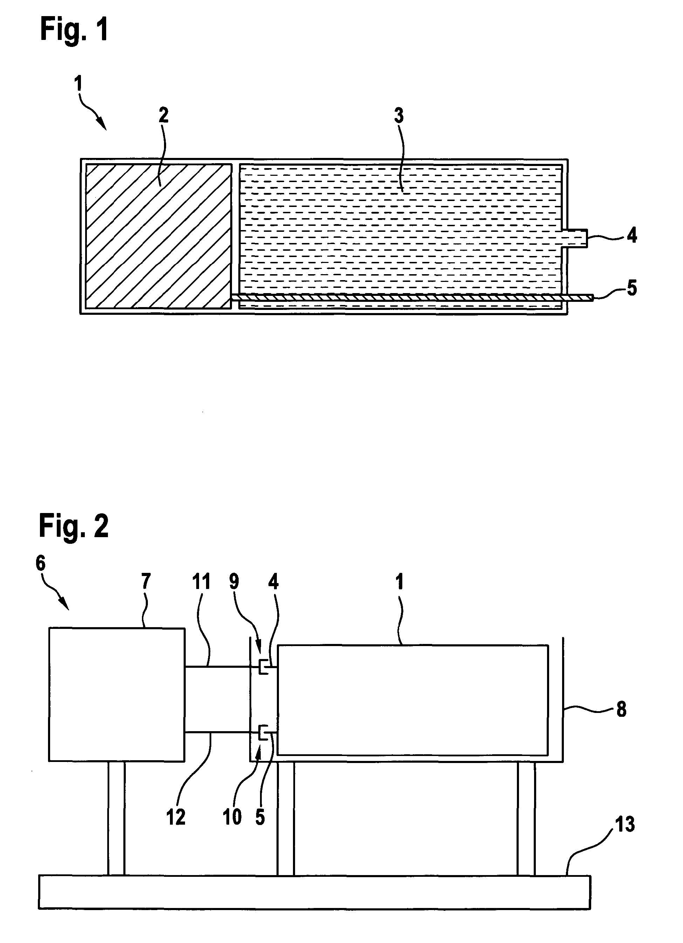

Figur 1 zeigt ein Vorratsmodul 1 gemäß einem Ausführungsbeispiel der Erfindung. Das Vorratsmodul 1 umfasst eine elektrische Speichervorrichtung 2 sowie eine thermische Speichervorrichtung 3. Die elektrische Speichervorrichtung 2 ist mit einem elektrischen Anschluss 5 verbunden, der insbesondere als schnelllösende Kupplung ausgelegt ist. Über den elektrischen Anschluss 5 kann die Energie der elektrischen Speichervorrichtung abgegeben werden. Weiterhin ist ein thermischer Anschluss 4 vorhanden, der ebenfalls als schnell lösbare Kupplung ausgelegt ist. Über den thermischen Anschluss 4 kann ein Kühlmittel, das innerhalb der thermischen Speichervorrichtung 3 gespeichert ist, abgegeben werden.

Bevorzugt besteht das Modul aus einem zylindrischen Behälter aus Stahl oder Aluminium mit einem Durchmesser von 0,5 m und einer Länge von 1,5 m. In diesem Behälter ist die elektrische Speichervorrichtung 2 in Form von elektrischen Akkumulatoren angebracht, während die thermische Speichervorrichtung 3 eine Kühlflüssigkeit umfasst, die ein latentwärmespeicherndes Material umfasst.

Die elektrische Energie ist bevorzugt mittels Lithium-Eisenphosphat-Akkumulatoren gespeichert, die eine Leistungsdichte von 3000 W/kg und eine Energiedichte von 120 Wh/kg aufweisen. Somit kann durch die elektrische Speichervorrichtung 2 eine Energie von 50 kW 140 Sekunden lang abgegeben werden, wobei die elektrische Speichervorrichtung eine Masse von lediglich 16,7 kg und ein Volumen von 50 I aufweist.

Die thermische Speichervorrichtung 3 umfasst ein Kühlmittel, das eine wässrige Emulsion aus mit Paraffin gefüllten Kunststoffkapseln umfasst. Die Kunststoffkapseln haben bevorzugt eine Abmessung von etwa 5 µm. Diese Emulsion besitzt eine Latentwärmekapazität von 40 kJ/kg bei einer vordefinierten Phasenübergangstemperatur. Diese Phasenübergangstemperatur beträgt insbesondere 20°C. Während eines Kühlvorgangs durch die wässrige Emulsion bleibt diese Temperatur konstant, da die aufgenommene Wärme ein Umwandeln der Phase des Paraffins von fest in flüssig bewirkt. Die thermische Speichervorrichtung weist insbesondere eine Masse von 100 kg bei einem Volumen von 100 I auf. Somit ist es möglich, 4 MJ Kühlenergie bereitzustellen.

Gemäß dem Ausführungsbeispiel beträgt die Gesamtmasse des Versorgungsmoduls etwa 170 kg. Daher kann das Vorratsmodul 1 sehr einfach gehandhabt werden. Insbesondere kann das Vorratsmodul in eine Aufnahmevorrichtung 8 eingebracht werden, was in Figur 2 gezeigt ist.

Figur 2 zeigt ein Wirksystem 6, das ein zu versorgendes Waffensystem 7 umfasst. Das Waffensystem 7 ist insbesondere ein Hochenergielaser-Waffensystem. Das Waffensystem 7 ist mittels einer Fluidleitung 11 und mittels einer elektrischen Leitung 12 mit der Aufnahmevorrichtung 8 verbunden. In die Aufnahmevorrichtung 8 ist das zuvor beschriebene Vorratsmodul 1 einbringbar. Weiterhin ermöglicht die Aufnahmevorrichtung 8, den elektrischen Anschluss 5 über ein elektrisches Kupplungselement 10 mit der elektrischen Leitung 12 zu verbinden, um somit das Waffensystem 7 mit elektrischer Energie zu versorgen. Außerdem ermöglicht die Aufnahmevorrichtung 8 durch ein thermisches Kopplungselement 9 den thermischen Anschluss 4 des Vorratsmoduls 1 mit der thermischen Leitung 11 zu verbinden, um so das Waffensystem 7 mit dem Kühlmittel zu versorgen.

Zur Versorgung des Waffensystems 7 ist vorgesehen, dass innerhalb des Waffensystems 7 eine elektrische Regelungseinheit vorhanden ist, die eine Energieversorgung des Waffensystems 7 aus der elektrischen Speichervorrichtung 2 regelt. Ebenso ist eine Kühlpumpe vorhanden, die das Kühlmittel aus der thermischen Speichervorrichtung 3 entnimmt und das Kühlmittel der thermischen Speichervorrichtung 3 wieder zuführt. Zwischen Entnahme und Zuführung des Kühlmittels wird das Kühlmittel verwendet, um Abwärme des Waffensystems 7 aufzunehmen und abzuführen.

Das Waffensystem 7 weist insbesondere eine Leistung von 50 kW auf, wobei eine optische Strahlleistung von 10 kW erzeugbar ist. Somit hat das Waffensystem einen Wirkungsgrad von 20%. Das Vorratsmodul 1 gemäß dem genannten Ausführungsbeispiel ermöglicht daher die Versorgung des Waffensystems 7 für eine Betriebszeit von zumindest 100 Sekunden.

Sobald das Versorgungsmodul 1 aufgebraucht ist, kann dieses aus der Aufnahmevorrichtung 8 entnommen werden, um ein weiteres Versorgungsmodul 1 einzusetzen. Auf diese Weise ist das Waffensystem 7 innerhalb einer sehr kurzen Zeitspanne wieder einsatzbereit, so dass sich das Wirksystem 6 in einer hohen Verfügbarkeitsrate auszeichnet. Das verbrauchte Vorratsmodul 1 kann anschließend durch eine Wiederverwendungsvorrichtung für einen erneuten Einsatz vorbereitet werden, indem die elektrische Speichervorrichtung aufgeladen wird und das Kühlmittel der thermischen Speichervorrichtung durch erneute Phasenumwandlung wieder in einen kühlbereiten Zustand gebracht wird.

Vorteilhafterweise weist das Wirksystem 6 zumindest zwei Aufnahmevorrichtungen 8 auf. Dadurch ist es möglich, dass ein Vorratsmodul 1 aus einer der Aufnahmevorrichtungen 8 entnommen werden kann, während ein weiteres Vorratsmodul 1 in der anderen Aufnahmevorrichtung 8 das Waffensystem 7 versorgt. Dies bedeutet, dass ein Austausch der Vorratsmodule 1 während des Betriebs des Waffensystems 7 möglich ist. Somit kann das Waffensystem 7 auch in einem Dauerzustand betrieben werden, was bei bekannten Systemen nicht oder nur mit sehr großem Aufwand möglich ist. Das Wirksystem 6 ist schließlich auf einer Plattform 13 angebracht. Dies bedeutet, dass sowohl das Waffensystem 7 als auch die Aufnahmevorrichtung 8 auf der Plattform 13 montiert sind. Die Plattform 13 ist dabei bevorzugt als mobile Plattform, insbesondere als Landfahrzeug oder als Wasserfahrzeug, ausgelegt. Daher ermöglicht die Plattform 13 einen sehr variablen und vielseitigen Einsatz des Waffensystems 7, da die Wirkeinheit 6 schnell und einfach an einen Ort verlegt werden kann, an dem diese benötigt wird.

### Bezugszeichenliste

- 1: Vorratsmodul
- 2: Elektrische Speichervorrichtung
- 3: Thermische Speichervorrichtung
- 4: Thermischer Anschluss
- 5: Elektrischer Anschluss
- 6: Wirksystem
- 7: Waffensystem
- 8: Aufnahmevorrichtung
- 9: Thermische Kupplung
- 10: Elektrische Kupplung
- 11: Thermische Leitung
- 12: Elektrische Leitung
- 13: Plattform

## Patentansprüche

1. Vorratsmodul (1) zum Versorgen eines Waffensystems (7), umfassend
- eine elektrische Speichervorrichtung (2),
- eine thermische Speichervorrichtung (3), wobei die thermische Speichervorrichtung (3) ein Kühlmittel speichert, und
- zumindest einen elektrischen Anschluss (5), über den Energie aus der elektrischen Speichervorrichtung (2) an das Waffensystem (7) übertragbar ist, und
- zumindest einen thermischen Anschluss (4), über den das Kühlmittel aus der thermischen Speichervorrichtung (3) an das Waffensystem (7) übertragbar ist,
- wobei das Vorratsmodul (1) austauschbar ist.

2. Vorratsmodul (1) nach Anspruch 1, **dadurch gekennzeichnet, dass** der elektrische Anschluss (5) und/oder der thermische Anschluss (4) eine schnelllösbare Kupplung umfasst.

3. Vorratsmodul (1) nach einem der vorhergehenden Ansprüche, **dadurch gekennzeichnet, dass** die elektrische Speichervorrichtung (2) eine Leistungsdichte von zumindest 1000 W/kg, insbesondere von zumindest 3000 W/kg, aufweist und/oder eine Energiedichte von zumindest 100 Wh/kg, insbesondere von zumindest 120 Wh/kg, aufweist.

4. Vorratsmodul (1) nach einem der vorhergehenden Ansprüche, **dadurch gekennzeichnet, dass** durch die elektrische Speichervorrichtung (2) eine Energieversorgung für eine Betriebszeit von zumindest 100 Sekunden, insbesondere von zumindest 150 Sekunden, des Waffensystems aufrechterhaltbar ist.

5. Vorratsmodul (1) nach einem der vorhergehenden Ansprüche, **dadurch gekennzeichnet, dass** die elektrische Speichervorrichtung (2) Lithium-Eisenphosphat Akkumulatoren umfasst.

6. Vorratsmodul (1) nach einem der vorhergehenden Ansprüche, **dadurch gekennzeichnet, dass** die thermische Speichervorrichtung (3) einen Latentwärmespeicher umfasst.

7. Vorratsmodul (1) nach Anspruch 6, **dadurch gekennzeichnet, dass** das Kühlmittel eine Latentwärmekapazität von zumindest 20 kJ/kg, insbesondere zumindest 40 kJ/kg, aufweist.

8. Wirksystem (6), umfassend
- zumindest ein zu versorgendes Waffensystem (7), insbesondere eine Laserwaffe,
- zumindest ein austauschbares Vorratsmodul (1) nach einem der vorhergehenden Ansprüche, und
- zumindest ein Aufnahmevorrichtung (8), die fest mit dem Waffensystem (7) verbunden ist, wobei
- das Vorratsmodul (1) in die Aufnahmevorrichtung (8) einbringbar ist, so dass eine Versorgung des Waffensystems (7) mit elektrischer Energie und mit Kühlmittel aus dem Vorratsmodul (1) erfolgt.

9. Wirksystem (6) nach Anspruch 8, **gekennzeichnet durch** eine Beladungsvorrichtung, insbesondere einen Kran, wobei das Vorratsmodul (1) durch die Beladungsvorrichtung in die Aufnahmevorrichtung (8) einbringbar und/oder aus der Aufnahmevorrichtung (8) ausbringbar ist.

10. Wirksystem (6) nach einem der Ansprüche 8 bis 9, **gekennzeichnet durch** zumindest zwei Aufnahmevorrichtungen (8), wobei eine Versorgung des Waffensystems (7) zwischen den Aufnahmevorrichtungen (8) umschaltbar ist, so dass das Waffensystem (7) kontinuierlich betreibbar ist.

11. Wirksystem (6) nach einem der Ansprüche 8 bis 10, **gekennzeichnet durch** eine Plattform (13), auf der das Waffensystem (7) und die Aufnahmevorrichtung (8) montiert sind, wobei die Plattform (13) als mobile Plattform ausgebildet ist.

## Claims

1. Supply module (1) for supplying a weapons system (7), comprising
- an electrical storage apparatus (2),
- a thermal storage apparatus (3), wherein the thermal storage apparatus (3) stores a coolant, and
- at least one electrical connection (5) by means of which energy can be transmitted from the electrical storage apparatus (2) to the weapons system (7), and
- at least one thermal connection (4) by means of which the coolant can be transmitted from the thermal storage apparatus (3) to the weapons system (7),
- wherein the supply module (1) is exchangeable.

2. Supply module (1) according to Claim 1, **characterized in that** the electrical connection (5) and/or the thermal connection (4) comprises a quick-release coupling.

3. Supply module (1) according to either of the preceding claims, **characterized in that** the electrical storage apparatus (2) has a power density of at least 1000 W/kg, in particular of at least 3000 W/kg, and/or an energy density of at least 100 Wh/kg, in particular of at least 120 Wh/kg.

4. Supply module (1) according to one of the preceding claims, **characterized in that** the electrical storage apparatus (2) can maintain an energy supply for an operating period of at least 100 seconds, in particular of at least 150 seconds, of the weapons system.

5. Supply module (1) according to one of the preceding claims, **characterized in that** the electrical storage apparatus (2) comprises rechargeable lithium iron phosphate batteries.

6. Supply module (1) according to one of the preceding claims, **characterized in that** the thermal storage apparatus (3) comprises a latent heat store.

7. Supply module (1) according to Claim 6, **characterized in that** the coolant has a latent heat capacity of at least 20 kJ/kg, in particular of at least 40 kJ/kg.

8. Active system (6), comprising
- at least one weapons system (7) which is to be supplied, in particular a laser weapon,
- at least one exchangeable supply module (1) according to one of the preceding claims, and
- at least one receptacle apparatus (8) which is fixedly connected to the weapons system (7), wherein
- the supply module (1) can be inserted into the receptacle apparatus (8) so that electrical energy and coolant from the supply module (1) are supplied to the weapons system (7).

9. Active system (6) according to Claim 8, **characterized by** a loading apparatus, in particular a crane, wherein the supply module (1) can be inserted into the receptacle apparatus (8) and/or can be removed from the receptacle apparatus (8) by the loading apparatus.

10. Active system (6) according to either of Claims 8 and 9, **characterized by** at least two receptacle apparatuses (8), wherein supply to the weapons system (7) can be switched over between the receptacle apparatuses (8), so that the weapons system (7) can be continuously operated.

11. Active system (6) according to one of Claims 8 to 10, **characterized by** a platform (13) on which the weapons system (7) and the receptacle apparatus (8) are mounted, wherein the platform (13) is in the form of a mobile platform.

## Revendications

1. Module de réserve (1) destiné à alimenter un système d'armement (7), comprenant
- un dispositif d'accumulation électrique (2),
- un dispositif d'accumulation thermique (3), le dispositif d'accumulation thermique (3) accumulant un réfrigérant, et
- au moins un raccord électrique (5) par le biais duquel de l'énergie peut être transmise du dispositif d'accumulation électrique (2) au système d'armement (7), et
- au moins un raccord thermique (4) par le biais duquel le réfrigérant peut être transmis du dispositif d'accumulation thermique (3) au système d'armement (7),
- le module de réserve (1) étant interchangeable.

2. Module de réserve (1) selon la revendication 1, **caractérisé en ce que** le raccord électrique (5) et/ou le raccord thermique (4) comprennent un coupleur à déconnexion rapide.

3. Module de réserve (1) selon l'une des revendications précédentes, **caractérisé en ce que** le dispositif d'accumulation électrique (2) possède une densité de puissance d'au moins 1000 W/kg, notamment d'au moins 3000 W/kg, et/ou possède une densité d'énergie d'au moins 100 Wh/kg, notamment d'énergie d'au moins 120 Wh/kg.

4. Module de réserve (1) selon l'une des revendications précédentes, **caractérisé en ce que** le dispositif d'accumulation électrique (2) permet de maintenir une alimentation en énergie pour une durée de fonctionnement d'au moins 100 secondes, notamment d'au moins 150 secondes du système d'armement.

5. Module de réserve (1) selon l'une des revendications précédentes, **caractérisé en ce que** le dispositif d'accumulation électrique (2) comprend des accumulateurs au lithium fer phosphate.

6. Module de réserve (1) selon l'une des revendications précédentes, **caractérisé en ce que** le dispositif d'accumulation thermique (3) comprend un accumulateur de chaleur latente.

7. Module de réserve (1) selon la revendication 6, **caractérisé en ce que** le réfrigérant possède une capacité en chaleur latente d'au moins 20 kJ/kg, notamment d'au moins 40 kJ/kg.

8. Système actif (6), comprenant
- au moins un système d'armement (7) à alimenter, notamment une arme à laser,
- au moins un module de réserve (1) interchangeable selon l'une des revendications précédentes, et
- au moins un dispositif d'accueil (8) qui est relié à demeure au système d'armement (7), avec lequel
- le module de réserve (1) peut être introduit dans le dispositif d'accueil (8) de telle sorte qu'ait lieu une alimentation du système d'armement (7) avec de l'énergie électrique et avec du réfrigérant en provenance du module de réserve (1).

9. Système actif (6) selon la revendication 8, **caractérisé par** un dispositif de chargement, notamment une grue, le module de réserve (1) pouvant être introduit dans le dispositif d'accueil (8) et/ou pouvant être sorti hors du dispositif d'accueil (8) par le dispositif de chargement.

10. Système actif (6) selon l'une des revendications 8 à 9, **caractérisé par** au moins deux dispositifs d'accueil (8), une alimentation du système d'armement (7) pouvant être permutée entre les dispositifs d'accueil (8), de sorte que le système d'armement (7) puisse fonctionner en continu.

11. Système actif (6) selon l'une des revendications 8 à 10, **caractérisé par** une plate-forme (13) sur laquelle sont montés le système d'armement (7) et le dispositif d'accueil (8), la plate-forme (13) étant réalisée sous la forme d'une plate-forme mobile.
